## Europäisches Patentamt

## European Patent Office

### Office européen des brevets

(19)

(11) **EP 0 856 161 B1**

(12) **EUROPÄISCHE PATENTSCHRIFT**

(45) Veröffentlichungstag und Bekanntmachung des Hinweises auf die Patenterteilung:
**01.09.1999  Patentblatt 1999/35**

(21) Anmeldenummer: **96934608.9**

(22) Anmeldetag: **10.10.1996**

(51) Int Cl.⁶: **G01R 33/02**

(86) Internationale Anmeldenummer:
**PCT/EP96/04395**

(87) Internationale Veröffentlichungsnummer:
**WO 97/14976 (24.04.1997 Gazette 1997/18)**

(54) **MAGNETFELDSENSOR**

MAGNETIC FIELD SENSOR

DETECTEUR DE CHAMP MAGNETIQUE

(84) Benannte Vertragsstaaten:
**AT BE CH FR GB LI NL SE**

(30) Priorität: **18.10.1995  DE 19538757**

(43) Veröffentlichungstag der Anmeldung:
**05.08.1998  Patentblatt 1998/32**

(73) Patentinhaber: **Mannesmann VDO AG**
**60326 Frankfurt (DE)**

(72) Erfinder:
- **GRILL, Thomas**
  **D-78050 Villingen-Schwenningen (DE)**
- **BACIC, Helmut**
  **D-78126 Königsfeld (DE)**
- **GRULER, Martin**
  **D-78554 Aixheim (DE)**
- **SPRINGMANN, Oliver**
  **D-78713 Schramberg (DE)**

(56) Entgegenhaltungen:
| | |
|---|---|
| EP-A- 0 137 896 | DE-A- 2 605 414 |
| DE-A- 4 136 451 | DE-A- 4 334 708 |
| US-A- 3 443 213 | US-A- 5 334 944 |

**Beschreibung**

Die Erfindung betrifft einen Magnetfeldsensor gemäß dem Oberbegriff des ersten Anspruchs. Sie geht aus von einem Magnetfeldsensor gemäß dem Dokument US-A-3 443 213. Dort wird ein Magnetfeldsensor beschrieben, dessen magnetisch vorgespannte Meßspule in einem Oszillator betrieben wird. Zur Messung der Feldstärke des Magnetfeldes kommt ein Kompensationsverfahren zur Anwendung. Für die Durchführung des Kompensationsverfahrens ist eine Rückkopplungsschaltung vorgesehen. Jedoch ist dieser Magnetfeldsensor für automotive Anwendungen zu störanfällig, da dessen Meßsignal beispielsweise durch Temperaturschwankungen negativ beeinflußt werden kann.

Das Dokument US-A-5 334 944 zeigt am Beispiel eines Magnetfeldsensors einen Differenzverstärker zur Verstärkung des Ausgangssignals des Sensorelements, wobei die Eingänge und Ausgänge des Differenzverstärkers für eine Umkehrbestromung des Sensorelements durch Schalter umpolbar sind. Dabei werden die Schalter durch eine Steuereinheit gleichzeitig betätigt, und zwar mit einer höheren Frequenz, als sich die Richtung des zu messenden Magnetfelds ändert. Diese Schaltungsanordnung offenbart jedoch keinen Magnetfeldsensor, der mittels eines Kompensationsverfahrens betrieben wird.

Aus dem Dokument EP 545 058 A1 ist ferner ein Richtungsänderungssensor für ein in Kraftfahrzeugen verwendbares Unfalldatenregistriergerät mit wenigstens zwei rechtwinklig zueinander angeordneten und jeweils einen Kern aus amorphem, ferromagnetischem Metall aufweisenden Zylinderspulen bekannt, wobei die geometrischen Achsen der Spulen nach dem Einbau des Unfalldatenregistriergerätes in ein Kraftfahrzeug im wesentlichen horizontal ausgerichtet und die Induktivitäten der Spulen durch das Erdmagnetfeld steuerbar sind, wobei im wesentlichen gleichgestaltete, jeweils eine der Spulen umfassende Oszillatoren vorgesehen sind und zur Festlegung der Arbeitsbereiche der Oszillatoren die amorphmetallischen Kerne der Spulen dauermagnetisch vorgespannt sind. Die magnetische Vorspannung der Spulenkerne erfolgt durch einen in räumlicher Nähe zu den Spulen angeordneten, vorzugsweise stabförmigen Dauermagneten, dessen Magnetfeld die Spulen durchflutet. Durch die magnetische Vorspannung wird erreicht, daß Frequenzänderungen des Oszillators, die durch die Einwirkung des Erdmagnetfeldes hervorgerufen werden, im linearen Bereich von dessen f/B-Kennlinie abgreifbar sind. Die Festlegung des Arbeitspunktes des Oszillators durch das Feld des Dauermagneten erfolgt unter Berücksichtigung eines praxisorientierten Signalhubs, der entsteht, wenn sich das Erdmagnetfeld der Vorspannung überlagert.

Die Schrift EP 503 370 A1 enthält einen Vorschlag für den konstruktiven Aufbau der Spule für einen magnetfeldgesteuerten Oszillator mit einem Spulenkörper, einer Wicklung und einem Spulenkern aus amorphem, ferromagnetischem Metall.

Die genannte Anordnung nach EP 545 058 A1 hat den Nachteil, daß der gewünschte Arbeitspunkt unter automotiven Betriebsbedingungen nicht stabil ist, was sich unmittelbar auf die Qualität der Messung auswirkt. Dem dort beschriebenen Meßaufbau lastet eine Temperaturdrift an, weil sich sowohl die magnetischen Eigenschaften des Dauermagneten als auch die Magnetisierung des amorphmetallischen Spulenkerns temperaturabhängig verändern. Auch wenn sich der Temperaturgang des Werkstoffs vom Dauermagneten und vom Spulenkern gegenläufig verhalten, ist es äußerst schwierig, Werkstoffpaarungen zu finden, bei denen sich im gewünschten Arbeitsbereich der Temperatureinfluß vom Amorphmetall und vom Dauermagneten gegenseitig aufheben, so daß in der Praxis unerwünschte Temperatureinflüsse das Meßergebnis stets überlagern.

Außerdem haben derartige Magnetfeldsoranordnungen den Nachteil eines hohen Abgleichaufwandes zur Einstellung des Arbeitspunktes des Oszillators. Zum Abgleich wird der die magnetische Vorspannung bewirkende Dauermagnet in der Umgebung der Spule(n) räumlich solange verschoben, bis durch Messen der in die Spule(n) induzierten Spannung die den gewünschten Arbeitspunkt definierende Lage des Dauermagneten ermittelt ist. Sodann muß der Dauermagnet in dieser Lage fixiert werden. Diese Vorgehensweise ist für ein massenhaft herzustellendes Produkt zu aufwendig, zumal diese Prozedur nur in einem magnetisch geschirmten Meßraum durchgeführt werden kann, um während des Abgleichvorganges Überlagerungen durch das Erdmagnetfeld auszuschließen.

Magnetfeldsensoranordnungen mit einem Dauermagneten in räumlicher Nähe zur Meßspule haben auch den Nachteil, daß es schwierig ist, den Dauermagneten so anzuordnen, daß sein Magnetfeld die Spule homogen durchflutet. Hierzu bedürfte es spezieller, aufwendiger Formgebungen für den Magneten. Eine ungleichmäßige Durchflutung der Spulen durch den Dauermagneten beeinträchtigt jedoch die mit der Meßanordnung erzielbare Meßgenauigkeit.

Alle diese Nachteile zwingen dazu, unter Berücksichtigung des automotiven Verwendungszwecks, der Bedingungen der Großserienfertigung und der in der Kraftfahrzeuginstrumentierung geltenden Kostenmaßstäbe nach einer anderen Lösung für einen gattungsgemäßen Magnetfeldsensor zu suchen. Insbesondere ist es die Aufgabe der vorliegenden Erfindung, eine Lösung aufzuzeigen, die eine über einen weiten Temperaturbereich stabile Magnetfeldmessung sicherstellt.

Es wird daher vorgeschlagen, bei einem Magnetfeldsensor,

a) bestehend aus einer ersten Spule mit einem ferromagnetischen Metallkern, wobei

- die Induktivität dieser Spule durch das Erdmagnetfeld steuerbar ist,
- diese Spule Teil eines Oszillators ist und
- der auf die Frequenz bezogene Arbeitsbereich des Oszillators durch die dauerhafte Eigenmagnetisierung des Metallkerns festgelegt ist,

b) und bestehend aus einer Regelungseinrichtung, die Abweichungen der Oszillatorfrequenz, die durch das auf die erste Spule einwirkende Erdmagnetfeld hervorgerufen werden, von einer Sollarbeitsfrequenz, die die Oszillatorfrequenz ohne Einwirkung des Erdmagnetfeldes ist, dadurch ausregelt, daß sie die Induktivität des Oszillators durch ein weiteres regelbares Magnetfeld beeinflußt, wobei eine zweite stromdurchflossene Spule dieses regelbare Magnetfeld erzeugt und die Regelungseinrichtung den Stromfluß durch die zweite Spule derart regelt, daß das von der zweiten Spule erzeugte Magnetfeld die Wirkung des auf die erste Spule einwirkenden Erdmagnetfeldes kompensiert,
c) in den Anschlußleitungen der zweiten Spule Schalter vorzusehen, die eine erste Steuereinheit jeweils gleichzeitig betätigt, wodurch sich die Richtung des Stromflusses durch die zweite Spule umkehrt,
d) wobei diese erste Steuereinheit die Schalter mit einer höheren Frequenz umschaltet, als diejenige Frequenz, mit der sich die Richtung der durch das Erdmagnetfeld gegebenen Durchflutung der ersten Spule ändert,
e) und den Ausgang des Magnetfeldsensors mit einer Rechenschaltung zu verbinden, die bei Anwesenheit des Erdmagnetfeldes für beide Richtungen des Stromflusses zunächst den jeweiligen Betrag und dann als ein der Feldstärke des Erdmagnetfeldes proportionales Meßsignal die Differenz aus diesen beiden Beträgen ermittelt.

Auf diese Weise werden durch das Erdmagnetfeld bedingte Änderungen der Oszillatorfrequenz durch die Regelungseinrichtung auf eine Sollarbeitsfrequenz hin dadurch ausgeregelt, daß die Induktivität des Oszillators, die aus einer mit einem amorphmetallischen Kern versehenen Spule besteht, durch ein zweites, definiert regelbares Magnetfeld beeinflußt und die zum Ausregeln der Oszillatorfrequenz erforderliche Energie als Maß für die Stärke des Erdmagnetfeldes ausgewertet wird. Dazu wird eine zweite Spule, die sogenannte Kompensationswicklung, vorzugsweise über die erste Spule, d.h. die Oszillatorspule, gewickelt. Der Stromfluß durch diese zweite Spule wird durch eine elektronische Regelungseinrichtung derart geregelt, daß das von der zweiten Spule erzeugte Magnetfeld die Wirkung des Erdmagnetfeldes auf die erste Spule gerade kompensiert. Dazu wird die Oszillatorfrequenz über eine geeignete Anpassungselektronik einem Regler zugeführt, der den Stromfluß durch die zweite Spule nach einem Vergleich der momentanen Oszillatorfrequenz mit einem in der Regelungseinrichtung gespeicherten Wert der Sollarbeitsfrequenz im Verhältnis zu den festgestellten Abweichungen der Oszillatorfrequenz von der Sollarbeitsfrequenz beeinflußt, um die momentane Oszillatorfrequenz durch eine Veränderung des Magnetfeldes der zweiten Spule zu der Sollarbeitsfrequenz zurückzuführen. Die dazu erforderliche Energie ist der Stärke des auf die erste Spule einwirkenden Erdmagnetfeldes proportional und kann daher als Meßsignal verwendet werden.

Die im Stand der Technik durch einen Dauermagneten vorgenommene Arbeitspunkteinstellung des Oszillators kann bei der vorliegenden Lösung auch durch das durch Bestromung der zweiten Spule erzeugte Magnetfeld erfolgen, wobei dann die bei Abwesenheit des Erdmagnetfeldes zum Erreichen des Arbeitspunktes des Oszillators erforderliche Stärke des von der Regelungseinrichtung bereitgestellten Stromes das Grundniveau des Stromflusses durch die zweite Spule, d.h. die Kompensationsspule, bestimmt.

Wenn durch eine geeignete erste Steuereinheit die Richtung des Stromflusses durch die zweite Spule derart in einem zeitlichen Takt umgepolt wird, daß sich die Richtung des Stromflusses schneller ändert als die Richtung der durch das Erdmagnetfeld gegebenen Durchflutung der ersten Spule, und wenn bei Anwesenheit des Erdmagnetfeldes für beide Stromrichtungen die jeweilige Stärke des zur Kompensation des Erdmagnetfeldes erforderlichen, durch die zweite Spule fließenden Stromes gemessen wird, ergibt sich durch Bildung der Differenz beider Beträge für den Strom ein zur Stärke des Erdmagnetfeldes proportionaler, von Temperatureinflüssen bereinigtes Meßsignal, da sich bei der Subtraktion beider Beträge für den Strom der einem Temperaturgang unterworfene, zur Einstellung des Arbeitspunktes des Oszillators benötigte Anteil des von der Regelungseinrichtung bereitgestellten Stromes gerade heraushebt.

Wenn darüber hinaus auch noch parasitäre Stromanteile der ersten Spule beseitigt werden sollen, empfiehlt es sich, die Richtung des Stromflusses durch diese erste Spule ebenfalls durch eine weitere Steuereinheit getaktet umzuschalten.

Im folgenden wird ein Ausführungsbeispiel der Erfindung anhand von drei Figuren erläutert, wobei

- die Figur 1 ein Blockschaltbild des erfindungsgemäßen Magnetfeldsensors,
- die Figuren 2A sowie 2B die Arbeitskennlinie für dessen Regelungseinrichtung für die beiden Bestromungsrichtungen der zweiten Spule zeigen und
- die Figur 3 den linearen Zusammenhang zwischen der Differenz der beiden Beträge des Stromes für beide Bestromungsrichtungen der zweiten Spule und der Feldstärke des Erdmagnetfeldes verdeutlicht.

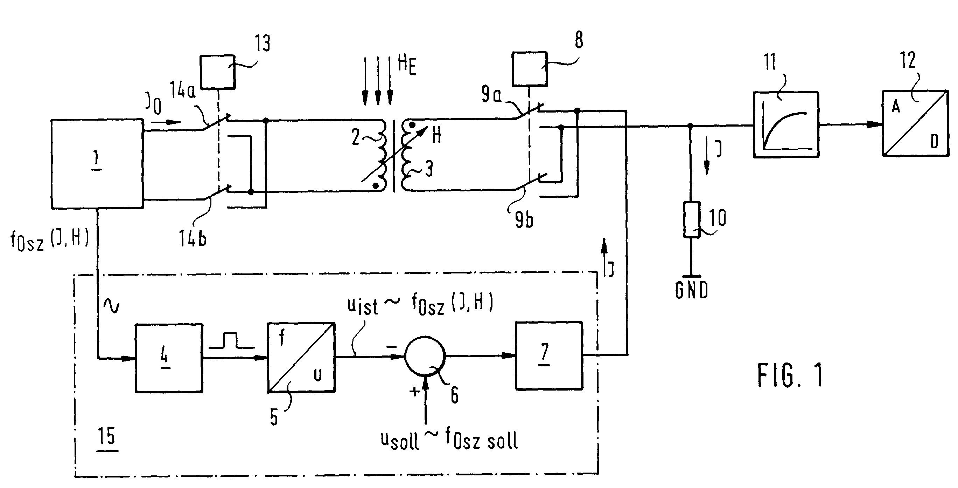

In der **Figur 1** bezeichnet 1 einen LC-Oszillator, der mit einer ersten Spule 2 betrieben wird. Um die Oszillatorfrequenz $f_{Osz}$ trotz der Einwirkung eines Erdmagnetfeldes $H_E$ auf die Induktivität 2 konstant zu halten, wird die feldstärkeabhängige, sinusförmige Oszillatorfrequenz $f_{Osz}$ durch eine geeignete Anpassungsschaltung 4 zunächst vorzugsweise in ein digital verwertbares Rechtecksignal umgewandelt und dann einem Frequenz-Spannungsumsetzer 5 zugeleitet, dessen Ausgang mit einem Subtrahierglied 6 verbunden ist, an dem ein der momentanen Oszillatorfrequenz $f_{Osz}$ proportionaler Spannungswert $u_{ist}$ von einem fest eingestellten Spannungssollwert $u_{soll}$, der der idealen Sollarbeitsfrequenz $f_{Osz\ soll}$ des Oszillators entspricht, subtrahiert wird. Die Sollarbeitsfrequenz $f_{Osz\ soll}$ des Oszillators ist diejenige Frequenz, die der Oszillator im unbelasteten Zustand, d.h. in Abwesenheit des Erdmagnetfeldes $H_E$, in seinem Arbeitspunkt annimmt. Genau genommen bezeichnet $H_E$ die Komponente des Erdmagnetfeldes in Spulenlängsrichtung. Die Differenz aus den beiden Spannungswerten $u_{soll}$ und $u_{ist}$ wird einem z.B. als PI-Regler ausgebildeten Regler 7 zugeführt, der den Strom J für die als Kompensationsspule wirkende zweite Spule 3 derart einstellt, daß die Spannungsdifferenz ($u_{soll}$ - $u_{ist}$) gegen Null geht und die durch das Erdmagnetfeld $H_E$ bewirkte Veränderung der Induktivität der ersten Spule 2 und die daraus resultierende Veränderung der Oszillatorfrequenz $f_{Osz}$ kompensiert wird, wodurch die Oszillatorfrequenz $f_{Osz}$ je nach der Regelgeschwindigkeit der Regelungseinrichtung mehr oder weniger konstant bleibt. In der praktischen Ausführung wird die zweite Spule 3 durch Überwickeln auf die erste Spule 2 aufgebracht, wobei beide Spulen aber elektrisch voneinander getrennt bleiben. Es ist vorteilhaft, die beiden Spulen mit gegenläufigem Wickelsinn zueinander anzuordnen.

Die Amplitude des Stromflusses J für die zweite Spule 3 ist der Stärke der Komponente des Erdmagnetfeldes $H_E$ in Spulen längsrichtung direkt proportional und ändert sich damit gleichermaßen wie die Stärke des Erdmagnetfeldes. Die eigentliche Meßgröße ist daher direkt durch Auswertung der Amplitude des Stromes J ableitbar. Dazu wird der durch die zweite Spule 3 fließende Strom J über einen Shuntwiderstand 10 gegen Masse GND geleitet, um den Strom J als Spannungssignal auswertbar zu machen. Da jedoch lediglich der Gleichanteil dieses Spannungssignals ein der Meßgröße proportionales Maß ist, wird das Spannungssignal über ein als Tiefpaß ausgelegtes Siebglied 11 einem Analog-Digital-Umsetzer 12 zur weiteren Verarbeitung zugeführt. Die weitere Auswertung erfolgt durch eine µP-gestützte Rechenschaltung, auf die hier aber nicht näher eingegangen werden soll, da ihr Aufbau nicht erfindungswesentlich ist. Die µP-gestützte Rechenschaltung, die das Meßsignal am Ausgang des Analog-Digital-Umsetzers 12 abgreift, ist in der Figur 1 deshalb auch nicht dargestellt.

Zur Umpolung der Bestromungsrichtung der zweiten Spule 3 werden ihre beiden elektrischen Anschlüsse jeweils für sich an synchron schaltende, durch eine Steuereinheit 8 betätigbare Wechselschalter 9a und 9b angeschlossen. Ebenso können die beiden elektrischen Anschlüsse der ersten Spule 2 über synchron schaltende, von einer Steuereinheit 13 betätigbare Wechselschalter 14a und 14b geführt werden, um den Stromfluß $J_0$ durch die erste Spule 2 richtungsmäßig wechselweise umzuschalten, wodurch parasitäre Stromanteile des Oszillators eliminiert werden können. Parasitäre Stromanteile sind Störeinflüsse, die dadurch entstehen, daß das Wechselfeld des LC-Oszillators 1 nicht ideal ist, sondern bedingt durch den schaltungstechnischen Aufbau des Oszillators von einem Gleichanteil überlagert wird, der von einem unvermeidbaren Querstrom im Oszillator 1 resultiert. In der praktischen Realisierung können die Steuereinheiten 8 und 13 gleich und auch bauteilmäßig zusammengefaßt sein. Die Steuereinheiten 8 und 13 schalten die von ihnen betätigten Wechselschalter 9a, 9b, 14a und 14b paarweise synchron und jeweils im gleichen Takt, wobei der Takt im Millisekundenbereich liegt.

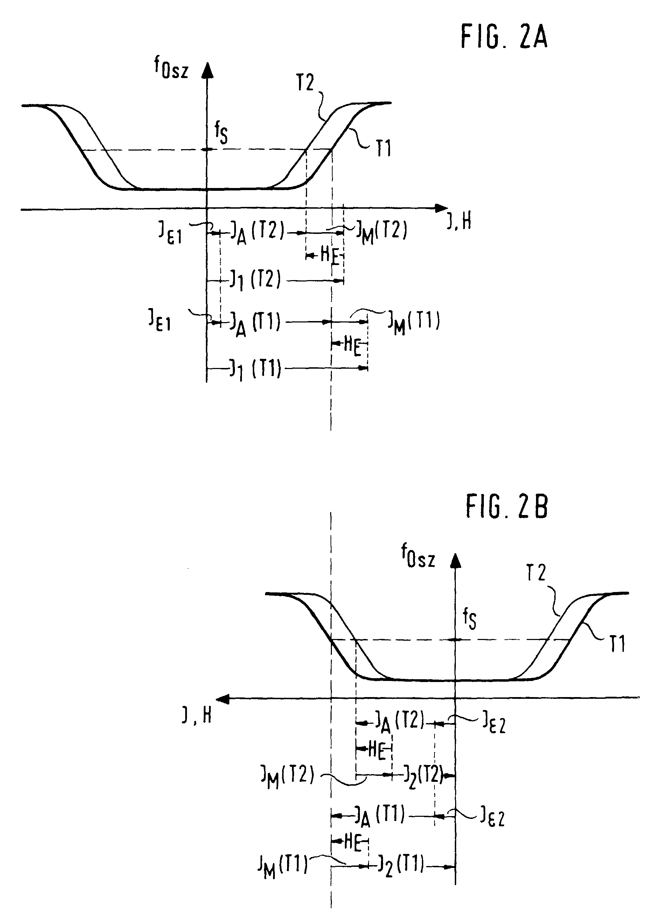

Die **Figur 2A** zeigt die Arbeitskennlinie für die Regelungseinrichtung bei zwei unterschiedlichen Betriebstemperaturen T1 und T2. Dabei ist die Frequenz $f_{Osz}$ des Oszillators 1 über der aus der Vorspannung und dem Erdmagnetfeld bestehenden Feldstärke H des auf die erste Spule 2 wirkenden Magnetfeldes bzw. über dem zur Feldstärke H proportionalen Stromfluß J für die zweite Spule 3 aufgetragen. Die Schalter 9a und 9b nehmen in der Figur 2A die Stellung ein, die in der Figur 1 dargestellt ist. Die **Figur 2B** zeigt dieselbe Arbeitskennlinie, ebenfalls bei den Betriebstemperaturen T1 und T2, jedoch bei umgekehrter Bestromungrichtung der zweiten Spule 3, d.h. also nach einer Betätigung der Schalter 9a und 9b.

Die Amplitude des Stromflusses J durch die zweite Spule 3 setzt sich aus drei Komponenten zusammen:

     1. einem Anteil $J_A$ zur Einstellung des Arbeitspunktes des Oszillators 1 bei der durch die Regelungseinrichtung konstant zu haltenden Sollarbeitsfrequenz $f_{Osz\ soll}$,

     2. einem Anteil $J_{\varepsilon 1}$ bzw. $J_{\varepsilon 2}$ zur Kompensation der parasitären Störeinflüsse im Oszillator 1 und

     3. dem Anteil $J_M$, der zur Kompensation der Komponente des Erdmagnetfeldes $H_E$ erforderlich ist,

so daß sich der vom Regler 7 aufzubringende Strom J in der ersten Bestromungsrichtung der zweiten Spule 3 insgesamt folgendermaßen darstellen läßt:

$$J_1 = J_A + J_{\varepsilon 1} + J_M$$

Der Anteil $J_A$ zur Einstellung des Arbeitspunktes ändert sich betragsmäßig je nach Lage der Arbeitskennlinie im $f_{Osz}/(J,H)$ - Diagramm, wobei die Kennlinie zu den Temperaturen T1 und T2 beispielhaft die in den Figuren 2A und 2B eingezeichnete Lage einnehmen mag. Nachdem durch Betätigung der Schalter 9a und 9b die Stromrichtung in der zweiten Spule 3 geändert wurde, ergibt sich der insgesamt erforderliche Strom J in Anwesenheit derselben Komponente des Erdmagnetfeldes $H_E$ zu $J_2 = J_A + J_{\varepsilon2} - J_M$

Bildet man bei einer bestimmten Temperatur (z.B. T1 oder T2) die Differenz von $J_1$ und $J_2$, so ergibt sich:

$$J_1 - J_2 = (J_A + J_{\varepsilon1} + J_M) - (J_A + J_{\varepsilon2} - J_M) =$$

$$(J_{\varepsilon1} - J_{\varepsilon2}) + 2J_M \cong 2J_M,$$

da der Anteil $(J_{\varepsilon1} - J_{\varepsilon2})$ durch eine richtungsmäßig wechselnde Bestromung der ersten Spule 2 gegen Null gebracht werden kann. Je nach den Genauigkeitsanforderungen an den Magnetfeldsensor mag der Einsatz der für den Stromrichtungswechsel erforderlichen Schalter 14a und 14b sogar verzichtbar sein, da der Anteil $(J_{\varepsilon1} - J_{\varepsilon2})$ im Vergleich zu $J_M$ betragsmäßig recht klein ist.

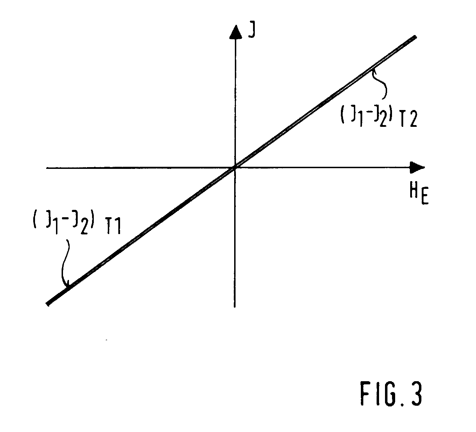

Beachtlich ist, daß der Strom $J_M$ direkt proportional zur Feldstärke des Erdmagnetfeldes $H_E$ ist, und zwar allein über eine aus Spulenlänge und Windungszahl bestehende Geometriekonstante der Spule. Diesen Zusammenhang verdeutlicht die **Figur 3**, in der der Differenzstrom $(J_1 - J_2)$ über der Feldstärke des Erdmagnetfeldes $H_E$ aufgetragen ist.

Mit der vorgeschlagenen Schaltungsanordnung wurde somit eine Lösung gefunden, die die Realisierung eines Magnetfeldsensors unter Berücksichtigung des automotiven Verwendungszwecks, der Bedingungen der Großserienfertigung und der in der Kraftfahrzeuginstrumentierung geltenden Kostenmaßstäbe ermöglicht. Insbesondere ist die Aufgabe einer über einen weiten Temperaturbereich stabilen Magnetfeldmessung durch die Maßnahme der mit dieser Schaltungsanordnung leicht durchführbaren Differenzmessung auf einfache Weise gelöst.

**Patentansprüche**

1. Magnetfeldsensor, bestehend

   a) aus einer ersten Spule (2) mit einem ferromagnetischen Metallkern, wobei

   • die Induktivität dieser Spule (2) durch das Erdmagnetfeld ($H_E$) steuerbar ist,
   • diese Spule (2) Teil eines Oszillators (1) ist und
   • der auf die Frequenz bezogene Arbeitsbereich des Oszillators (1) durch die dauerhafte Eigenmagnetisierung des Metallkerns festgelegt ist,

   b) aus einer Regelungseinrichtung (15), die Abweichungen der Oszillatorfrequenz ($f_{Osz}$), die durch das auf die erste Spule (2) einwirkende Erdmagnetfeld ($H_E$) hervorgerufen werden, von einer Sollarbeitsfrequenz ($f_{Osz\,soll}$) die die Oszillatorfrequenz ohne Einwirkung des Erdmagnetfeldes ($H_E$) ist, dadurch ausregelt, daß sie die Induktivität des Oszillators (1) durch ein weiteres regelbares Magnetfeld beeinflußt, wobei eine zweite stromdurchflossene Spule (3) dieses regelbare Magnetfeld erzeugt und die Regelungseinrichtung (15) den Stromfluß (J) durch die zweite Spule derart regelt, daß das von der zweiten Spule (3) erzeugte Magnetfeld die Wirkung des auf die erste Spule (2) einwirkenden Erdmagnetfeldes ($H_E$) kompensiert,

   **dadurch gekennzeichnet,**

   c) daß in den Anschlußleitungen der zweiten Spule (3) Schalter (9a und 9b) vorgesehen sind, die eine erste Steuereinheit (8) jeweils gleichzeitig betätigt, wodurch sich die Richtung des Stromflusses (J) durch die zweite Spule (3) umkehrt,
   d) daß diese erste Steuereinheit (8) die Schalter (9a und 9b) mit einer höheren Frequenz umschaltet als diejenige Frequenz, mit der sich die Richtung der durch das Erdmagnetfeld gegebenen Durchflutung der ersten Spule (2) ändert, und
   e) daß der Ausgang des Magnetfeldsensors mit einer Rechenschaltung verbunden ist, die bei Anwesenheit des Erdmagnetfeldes ($H_E$) für beide Richtungen des Stromflusses zunächst den jeweiligen Betrag ($J_1$ bzw. $J_2$) und dann als ein der Feldstärke des Erdmagnetfeldes ($H_E$) proportionales Meßsignal die Differenz aus diesen beiden Beträgen ($J_1$ und $J_2$) ermittelt.

2. Magnetfeldsensor nach Anspruch 1, dadurch gekennzeichnet, daß die Regelungseinrichtung (15) im wesentlichen aus einer Anpassungselektronik (4), einem Frequenz-Spannungsumsetzer (5), einer Subtrahierstelle (6) und einem Regler (7) besteht, wobei die Regelungseinrichtung (15) die Oszillatorfrequenz ($f_{Osz}$) über die Anpassungselektronik (4) und den Frequenz-Spannungsumsetzer (5) dem Regler (7) zuführt, der den Strom (J) für die zweite Spule (3) nach einem an der Subtrahierstelle (6) durchgeführten Vergleich der momentanen Oszillatorfrequenz ($f_{Osz}$) mit einem in der Regelungseinrichtung (15) gespeicherten Wert der Sollarbeitsfrequenz ($f_{Osz\,soll}$) im Verhältnis zu der dazu festgestellten Abweichung der Oszillatorfrequenz ($f_{Osz}$) beeinflußt, um die momentane Oszillatorfrequenz ($f_{Osz}$) durch eine Veränderung des Magnetfeldes der zweiten Spule (3) zu ihrer Sollarbeitsfrequenz ($f_{Osz\ soll}$) zurückzuführen.

3. Magnetfeldsensor nach einem der vorangegangenen Ansprüche, dadurch gekennzeichnet,
daß die Regelungseinrichtung (15) den auf die Frequenz bezogenen Arbeitspunkt des Oszillators (1) durch ein durch Bestromung der zweiten Spule (3) erzeugtes Magnetfeld einstellt, wobei die bei Abwesenheit des Erdmagnetfeldes ($H_E$) zum Erreichen des durch die Sollarbeitsfrequenz ($f_{Osz\ soll}$) gekennzeichneten Arbeitspunktes des Oszillators (1) erforderliche Stärke des von der Regelungseinrichtung (15) bereitgestellten Stromes (J) das Grundniveau des Stromflusses durch die zweite Spule (3) festlegt.

4. Magnetfeldsensor nach einem der vorangegangenen Ansprüche, dadurch gekennzeichnet,
daß die zweite Spule (3) über die erste Spule (2) gewickelt ist.

5. Magnetfeldsensor nach einem der vorangegangenen Ansprüche, dadurch gekennzeichnet,
daß in den Anschlußleitungen der ersten Spule (2) Schalter (14a und 14b) vorgesehen sind, die eine zweite Steuereinheit (13) in einem vorgegebenen Takt jeweils gleichzeitig betätigt, wodurch sich die Richtung des Stromflusses ($J_0$) durch die erste Spule (2) zur Beseitigung parasitärer Stromanteile im Oszillator (1) umkehrt.

6. Magnetfeldsensor nach Anspruch 5, dadurch gekennzeichnet,
daß die erste Steuereinheit (8) und die zweite Steuereinheit (13) in einer Baueinheit zusammengefaßt sind und die von ihnen betätigten Schalter (9a; 9b bzw. 14a; 14b) jeweils im gleichen Takt schalten, wobei der Takt im Millisekundenbereich liegt.

## Claims

1. Magnetic field sensor, comprising

   a) a first coil (2) having a ferromagnetic metal core,

   - the inductance of this coil (2) being controllable by the earth's magnetic field ($H_E$),
   - this coil (2) being part of an oscillator (1) and
   - the frequency-related working range of the oscillator (1) being defined by the permanent self-magnetization of the metal core,

   b) a control system (15) which corrects deviations of the oscillator frequency ($f_{osc}$), which are brought about by the earth's magnetic field ($H_E$) acting on the first coil (2), from a desired working frequency ($f_{osc\ des}$), which is the oscillator frequency without the effect of the earth's magnetic field ($H_E$), by influencing the inductance of the oscillator (1) by a further adjustable magnetic field, a second current-carrying coil (3) generating this adjustable magnetic field and the control system (15) adjusting the current flow (J) through the second coil in such a way that the magnetic field generated by the second coil (3) compensates the effect of the earth's magnetic field ($H_E$) acting on the first coil (2),

**characterized**

   c) in that switches (9a and 9b) are provided in the connecting lines of the second coil (3) and are in each case simultaneously actuated by means of a first control unit (8), as a result of which the direction of the current flow (J) through the second coil (3) reverses,
   d) in that this first control unit (8) switches over the switches (9a and 9b) at a higher frequency than that frequency at which the direction of the earth's magnetic field permeation of the first coil (2) changes, and
   e) in that the output of the magnetic field sensor is connected to an arithmetic circuit which, in the presence of the earth's magnetic field ($H_E$), for both directions of the current flow, firstly determines the respective amount ($J_1$ and $J_2$) and then determines, as a measurement signal proportional to the field strength of the earth's magnetic field ($H_E$), the difference of these two amounts ($J_1$ and $J_2$).

2. Magnetic field sensor according to Claim 1, characterized
in that the control system (15) essentially consists of matching electronics (4), a frequency-voltage converter (5), a subtracter (6) and a controller (7), the control system (15) feeding the oscillator frequency ($f_{osc}$) via the matching electronics (4) and the frequency-voltage converter (5) to the controller (7), which influences the current (J) for the second coil (3), after a comparison, carried out at the subtracter (6), of the instantaneous oscillator frequency ($f_{osc}$) with a value of the desired working frequency value ($f_{osc\ des}$) stored in the control system (15), in proportion to the deviation of the oscillator frequency ($f_{osc}$) which is found in relation thereto, in order to return the instantaneous oscillator frequency ($f_{osc}$) to its desired working frequency ($f_{osc\ des}$) by changing the magnetic field of the second coil (3).

3. Magnetic field sensor according to one of the preceding claims, characterized

in that the control system (15) sets the frequency-related working point of the oscillator (1) by a magnetic field generated by causing current to flow through the second coil (3), the strength, required to attain the working point, characterized by the desired working frequency ($f_{osc\ des}$), of the oscillator (1) in the absence of the earth's magnetic field ($H_E$), of the current (J) made available by the control system (15) determining the basic level of the current flow through the second coil (3).

4. Magnetic field sensor according to one of the preceding claims, characterized

in that the second coil (3) is wound over the first coil (2).

5. Magnetic field sensor according to one of the preceding claims, characterized

in that switches (14a and 14b) are provided in the connecting lines of the first coil (2) and are in each case simultaneously actuated by means of a second control unit (13) with a preset cycle, as a result of which the direction of the current flow ($J_0$) through the first coil (2) reverses to eliminate parasitic current components in the oscillator (1).

6. Magnetic field sensor according to Claim 5, characterized

in that the first control unit (8) and the second control unit (13) are combined in a constructional unit and switch the switches (9a; 9b and 14a; 14b), actuated by them, in each case with the same cycle, the cycle being in the millisecond range.

## Revendications

1. Détecteur de champ magnétique constitué

     a) d'une première bobine (2) avec un noyau métallique ferromagnétique,

     ○   l'inductance de ladite bobine (2) pouvant être commandée par le champ magnétique terrestre ($H_E$),
     ○   ladite bobine (2) faisant partie d'un oscillateur (1) et
     ○   la zone de fonctionnement de l'oscillateur (1) référée à la fréquence étant déterminée par la magnétisation inhérente permanente dudit noyau métallique,

     b) d'un dispositif d'asservissement (15) qui compense des écarts de la fréquence d'oscillateur ($f_{Osz}$), qui sont provoqués par le champ magnétique terrestre ($H_E$) agissant sur la première bobine (2), par rapport à une fréquence de travail de référence ($f_{Osz\ soll}$) qui est la fréquence d'oscillateur sans l'action du champ magnétique terrestre ($H_E$) de telle sorte qu'elle agit sur l'inductance de l'oscillateur (1) par un autre champ magnétique réglable, une deuxième bobine (3) parcourue par le courant engendrant ledit champ magnétique et le dispositif d'asservissement (15) régulant le flux de courant (J) traversant la deuxième bobine de telle sorte que le champ magnétique engendré par la deuxième bobine (3) compense l'action du champ magnétique terrestre ($H_E$) agissant sur la première bobine (2),

     caractérisé par le fait

     c) que dans les lignes de raccordement de la deuxième bobine (3) sont prévus des commutateurs (9a et 9b) qu'actionne respectivement simultanément une première unité de commande (8), ce qui fait que le sens du flux de courant (J) traversant la deuxième bobine (3) est inversé,
     d) que cette première unité de commande (8) commute les commutateurs (9a et 9b) avec une fréquence plus élevée que la fréquence avec laquelle varie le sens du flux donné par le champ magnétique terrestre traversant la première bobine (2), et
     e) que la sortie du détecteur de champ magnétique est reliée à un circuit de calcul qui, en présence du champ magnétique terrestre ($H_E$), détermine pour les deux sens du flux de courant tout d'abord le montant ($J_1$ ou $J_2$) et, ensuite, comme un signal de mesure proportionnel à l'intensité du champ magnétique terrestre ($H_E$), la différence de ces deux montants ($J_1$ et $J_2$).

2. Détecteur de champ magnétique selon la revendication 1,
caractérisé par le fait
que le dispositif d'asservissement (15) est constitué, pour l'essentiel, d'une électronique d'adaptation (4), d'un convertisseur fréquence-tension (5), d'un point de soustraction (6) et d'un régulateur (7), ledit dispositif d'asservissement (15) acheminant la fréquence d'oscillateur ($f_{Osz}$), par l'intermédiaire de ladite électronique d'adaptation (4) et dudit convertisseur fréquence-tension (5), au régulateur (7) qui agit, après une comparaison effectuée audit point de soustraction de la fréquence d'oscillateur momentanée ($f_{Osz}$) avec une valeur de la fréquence de travail de référence ($f_{Osz\ soll}$) mémorisée dans ledit dispositif d'asservissement, sur le courant (J) pour la deuxième bobine (3) par rapport à l'écart déterminé à ce sujet de ladite fréquence d'oscillateur ($f_{Osz}$), afin de ramener, par une variation du champ magnétique de la deuxième bobine (3), la fréquence d'oscillateur momentanée ($f_{Osz}$) à sa fréquence de travail de référence ($f_{Osz\,soll}$).

3. Détecteur de champ magnétique selon l'une quelconque des revendications précédentes, caractérisé par le fait que le dispositif d'asservissement (15) règle le point de fonctionnement de l'oscillateur (1) référé à la fréquence par un champ magnétique engendré par l'application de courant à la deuxième bobine (3), l'intensité du courant (J) fourni par le dispositif d'asservissement (15) nécessaire, en cas d'absence du champ magnétique terrestre ($H_E$), pour atteindre le point de fonctionnement de l'oscillateur (1) caractérisé par la fréquence de travail de référence ($f_{Osz\,soll}$), déterminant le niveau de base du flux de courant traversant la deuxième bobine (3).

4. Détecteur de champ magnétique selon l'une quelconque des revendications précédentes, caractérisé par le fait que la deuxième bobine (3) est enroulée sur la première bobine (2).

5. Détecteur de champ magnétique selon l'une quelconque des revendications précédentes, caractérisé par le fait que dans les lignes de raccordement de la première bobine (2) sont prévus des commutateurs (14a et 14b) qu'actionne, à une cadence prédéterminée, respectivement simultanément une deuxième unité de commande (13), le sens du flux de courant ($J_0$) traversant la première bobine (2) s'inversant pour l'élimination de composantes de courant parasitaires dans l'oscillateur (1).

6. Détecteur de champ magnétique selon l'une quelconque des revendications précédentes, caractérisé par le fait que la première unité de commande (8) et la deuxième unité de commande (13) sont regroupées dans un sous-ensemble et que les commutateurs (9a ; 9b ou 14a ; 14b) actionnés par ces dernières commutent respectivement à la même cadence, ladite cadence étant située dans la plage des millisecondes.

FIG. 1

FIG. 2A

FIG. 2B

FIG.3